# EUROPÄISCHE PATENTANMELDUNG

(11) **EP 1 213 770 A2**
(43) Veröffentlichungstag der Anmeldung: **12.06.2002**
(21) Anmeldenummer: 01126263.1
(22) Anmeldetag: 06.11.2001
(51) Int. Cl.: H01L 31/0203, H01L 33/00, H05K 3/30, H01L 23/28

(54) **Gemouldetes elektronisches Bauelement**

(30) Priorität: 25.11.2000 DE 10058622
(71) Anmelder: Vishay Semiconductor GmbH, 74072 Heilbronn (DE)
(72) Erfinder: Scheidle, Helmut, 74196 Neuenstadt (DE)
(74) Vertreter: Kolb, Georg

(57) **Zusammenfassung**

2.1. Bei gemouldeten elektronischen Bauelementen verbleibt in der Trennebene des Mouldwerkzeugs ein Grat (Ridge) aus Mouldwerkstoff im Gehäuse. Besonders nachteilig wirkt sich dies aus, wenn der Grat durch eine den Anschlussbeinchen gegenüber liegende Seitenfläche führt, an der eine Saugnadel andockt.
2.2. Gemouldetes elektronisches Bauelement mit einer Vielzahl in einer Ebene aus einer Seitenfläche eines im wesentlichen quaderförmigen Gehäuses austretenden Anschlussbeinchen und einem die anderen Seitenflächen in der Ebene der Anschlussbeinchen umlaufenden Grats, dessen Dicke im wesentlichen der Dicke der Anschlussbeinchen entspricht, dadurch gekennzeichnet, dass an derjenigen Seitenfläche, die der Seitenfläche der Anschlussbeinchen gegenüber liegt, in der Ebene der Anschlussbeinchen der Grat in einem zusammen hängenden Teil der Seitenfläche in eine Nut übergeht und so das Bauelement besser von einem Werkzeug auf einer Leiterplatte plaziert werden kann.
2.3. Die Erfindung eignet sich insbesondere zur Herstellung von gemouldeten elektronischen Bauelementen, bei denen die Trennebene durch diejenige Gehäusefläche verläuft, an der eine Saugnadel andockt.

## Beschreibung

Die Erfindung betrifft ein gemouldetes elektronisches Bauelement nach dem Oberbegriff des Patentanspruchs 1.

Ein solches gemouldetes elektronisches Bauelement ist beispielsweise aus der deutschen Offenlegungsschrift DE 196 53 054 A1 bekannt. Bei solchen gemouldeten elektronischen Bauelementen werden Halbleiterchips (optoelektronischer Sender und Empfänger, Integrierter Schaltkreis zur Signalaufbereitung) erst maschinell auf einen metallenen Leiterstreifen geklebt oder gelötet und danach mittels dünner Gold- oder Aluminiumdrähte miteinander und mit dem Leiterstreifen kontaktiert. Danach werden Halbleiterchips und Leiterstreifen in den meisten Fällen durch ein Mouldverfahren mit einem thermoplastischen Kunststoff, beispielsweise einem Kunstharz, umhüllt und dadurch ein Gehäuse zum Schutz dieser Baugruppe hergestellt.

Bei der Herstellung des Gehäuses verbleibt in der Trennebene der Mouldform zwischen dem Ober- und Unterteil ein Grat oder Vorsprung aus dem Mouldwerkstoff, für den auch die englische Bezeichnung "Ridge" verwendet wird. Besonders nachteilig wirkt sich dies aus, wenn der Grat durch eine Seitenfläche des Gehäuses führt, an der zu einem späteren Zeitpunkt eine Saugnadel eines Bestückungsautomats andockt, um das Bauelement aufzunehmen und es beispielsweise auf einer Leiterplatte zu plazieren. Bedingt durch den Grat schließt die Saugnadel nicht dicht ab, sondern zieht sehr viel Fremdluft, wodurch ein aufzunehmendes Bauelement nicht kräftig genug angezogen und damit gehalten wird. Zudem kippt das Bauelement beim Aufnehmen und nimmt an der Saugnadel eine verkantete und undefinierbare Position ein. Aus diesen Gründen gehen beim Transport unannehmbar viele Bauelemente verloren oder werden ungenau plaziert.

Man versucht daher, den Grat (Ridge) so klein als möglich zu halten, was aber Mouldwerkzeuge mit sehr engen Toleranzen, eine sehr präzise Fertigung und zusätzliche Kontrollen erfordert. Diese Maßnahmen bedeuten aber merklich erhöhte Herstellkosten, ohne dass das Problem wirklich gelöst ist.

Eine Möglichkeit, den Grat zu vermeiden, besteht darin, das elektronische Bauelement nicht mittels eines Mouldprozesses mit einem Kunstharz zu umhüllen, sondern durch Vergießen in einer Gießform ein Gehäuse aus einem gießfähigem Kunststoff herzustellen.

Das Vergießen hat gegenüber dem Moulden jedoch viele Nachteile, beispielsweise dass im Vergleich zum Moulden große Wandstärken notwendig und diese nur mit relativ großen Toleranzen und schlechter Maßhaltigkeit (große Schwankungen) bei den Außenabmessungen zu verwirklichen sind. Ein Mouldteil kann daher immer kleiner und platzsparender hergestellt werden als ein Gießteil.

Weiterhin ist keine definierte Gehäusekante an der Einguss-Seite möglich. Es bilden sich Menisken aus bzw. das Gießharz läuft an den Anschlussbeinchen des elektronischen Bauelements hoch, was sich beim nachfolgenden Biegen der Anschlussbeinchen als sehr hinderlich heraus stellt. Zudem wirkt sich die umständliche Handhabung beim Gießprozess störend aus. Speziell bei Side-View-Bauelementen (bei denen die optische Strahlrichtung senkrecht zur Richtung der noch nicht gebogenen Anschlussbeinchen verläuft) müssen die Gießformen umständlich für jeden Gießvorgang zusammengefügt werden.

Ein weiterer Punkt betrifft die Sauberkeit. Mischungen müssen umständlich hergestellt werden und entsprechende Sauberkeit ist schwer einzuhalten. Beim Mischen werden außerdem oft fehlerhafte Harzmischungen zusammen gestellt. Weiterhin sind die Gießformen teuer. Hohe Fertigungskosten entstehen zusätzlich, weil die Kavität und teilweise Dichtmaterialien als Verbrauchsmaterial eingesetzt werden müssen und weil ein Kavitätenwechsel ist alle 20 bis 100 Schuss notwendig ist.

Der Erfindung liegt die Aufgabe zugrunde, ein gemouldetes elektronisches Bauelement nach dem Oberbegriff des Anspruchs 1 anzugeben, das ohne Schwierigkeiten von einer Bestückungsmaschine aufgenommen und auf einer Leiterplatte plaziert werden kann.

Gelöst wird diese Aufgabe durch eine Anordnung mit den im Anspruch 1 angegebenen Merkmalen.

Das gemouldete elektronische Bauelement nach Anspruch 1 weist den Vorteil auf, dass es von automatischen Bestückungsmaschinen problemlos aufgenommen, sicher gehalten und exakt plaziert werden kann, ohne dass bei der Herstellung des gemouldeten elektronischen Bauelements besonders enge Toleranzen eingehalten oder zur Herstellung besondere Werkzeuge zu verwenden sind, oder dass auf den problematischen Gießprozess zurück gegriffen werden muss.

Die Erfindung eignet sich insbesondere für gemouldete elektronische Bauelemente, deren Trennebene durch diejenige Gehäusefläche verläuft, an die die Saugnadel einer Bestückungsmaschine andockt.

Vorteilhafte Ausgestaltungen des gemouldeten elektronischen Bauelements nach Anspruch 1 sind in den Unteransprüchen angegeben.

Die Erfindung wird nun anhand eines Ausführungsbeispiels unter Zuhilfenahme der Zeichnung erläutert. Es zeigen
- Fig. 1:: eine Draufsicht auf eine Baugruppe, bestehend aus einem Leiterstreifen, der bereits mit kontaktierten Halbleiterbauelementen bestückt ist,
- Fig. 2a:: eine Draufsicht auf ein elektronisches Bauelement, das die Baugruppe nach Fig. 1 beinhaltet und zusätzlich mit einem gemouldeten Gehäuse versehen ist,
- Fig. 2b:: eine Seitenansicht auf das gemouldetes elektronische Bauelement nach Fig. 2a,
- Fig. 3:: eine Seitenansicht (schnittbildliche Darstellung) des gemouldeten elektronischen Bauelements nach Fig. 2a und 2b bei einem nachfolgenden Fertigungsschritt,
- Fig. 4a - d:: das fertig gemouldete elektronische Bauelement in vier verschiedenen Ansichten und
- Fig. 5:: ein gemouldetes elektronisches Bauelement nach dem Stand der Technik.

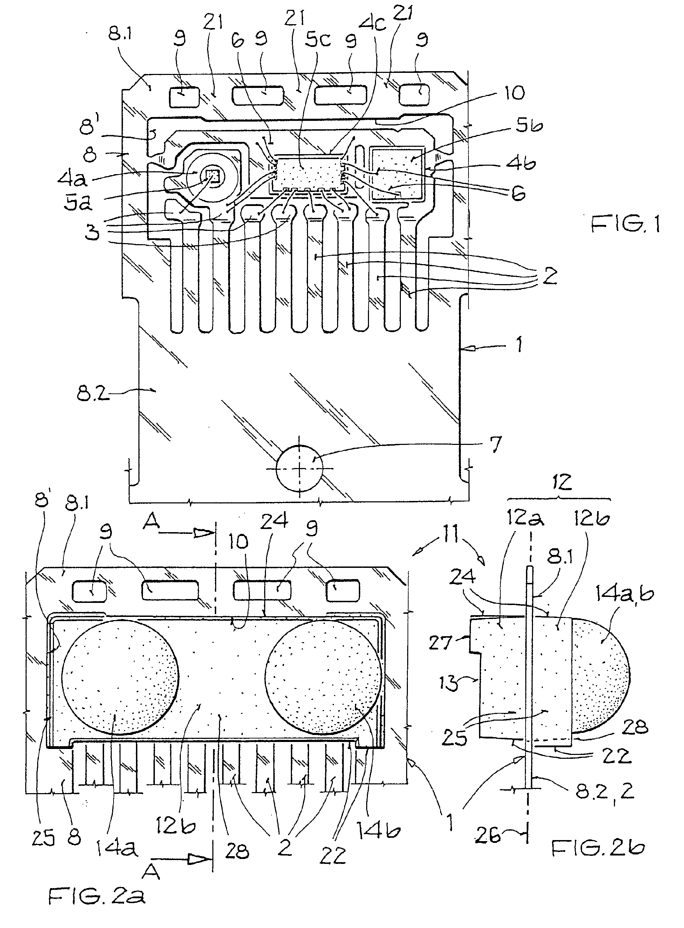

Die **Fig. 1** zeigt einen Leiterstreifen **1**, der beispielsweise aus einer Kupferlegierung besteht und auf bekannte Art und Weise aus einem dünnen Blech herausgestanzt oder herausgeätzt wird. Ebenfalls durch Stanzen oder Ätzen werden eine Vielzahl von Anschlussbeinchen **2** mit Bondflächen **3** und Bestückungsflächen **4a, 4b** und **4c** für elektronische oder optoelektronische Halbleiterbauelemente **5a, 5b** und **5c** ausgeformt. Die Halbleiterbauelemente **5a, 5b** und **5c** werden mittels eines Haftstoffes wie beispielsweise eines Lotes oder eines leitfähigen Klebstoffes stoffschlüssig auf den Bestückungsflächen **4a, 4b** und **4c** des Leiterstreifens **1** befestigt.

Bei dem Halbleiterbauelement **5a** handelt es sich beispielsweise um einen optoelektronischen Sender (Transmitter), bei dem Halbleiterbauelement **5b** beispielsweise um einen optoelektronischen Empfänger (Receiver) und bei dem Halbleiterbauelement **5c** beispielsweise um einen Integrierten Schaltkreis zum Aufbereiten der vom optoelektronischen Empfänger **5b** abgegebenen elektrischen Signale. Die Halbleiterbauelemente **5a, 5b** und **5c** sind mittels dünner Bonddrähte **6** aus einer Aluminium- oder Goldlegierung untereinander bzw. mit den Bondflächen **3** der Anschlussbeinchen **2** verbunden.

Weiterhin weist der Leiterstreifen **1** einen Rahmen **8** mit einer inneren Begrenzung **8'** und Rahmenteilen **8.1** und **8.2** auf. In den Rahmenteil **8.2** ist eine Positionier- und Transportöffnung **7** in Form eines Rundloches eingebracht, und in den Rahmenteil **8.1** sind Öffnungen **9** in Form von Langlöchern eingebracht, wobei zwischen den Öffnungen **9** Stege **21** angeordnet sind. Zudem weist der Rahmenteil **8.1** eine Verbreiterung **10** auf. Sinn und Zweck der Öffnungen **9,** der Stege **21** und der Verbreiterung **10** werden weiter unten beschrieben.

Der Rahmen **8** befindet sich beim Mouldvorgang zwischen Ober- und Unterteil der Mouldform. Seine innere Begrenzung **8'** verläuft dabei um die eigentliche Mouldform, da er einen geringfügig größeren Durchmesser aufweist als das spätere, durch die Mouldform hergestellte Gehäuse **12** (Fig. 2a, b).

Die **Fig. 2a** und **2b** zeigen ein aus der Baugruppe der Fig. 1 bestehendes, noch nicht fertig gestelltes elektronisches Bauelement **11** zur gerichteten, bidirektionalen optischen Datenübertragung in einem späteren Stadium der Fertigung. Ein solches Bauelement **11** wird auch als Transceiver (aus **Trans**mitter und Re**ceiver**) bezeichnet. Die Halbleiterbauelemente **5a-c** (Fig. 1) und die Bonddrähte **9** (Fig. 1) wurden zur Herstellung eines schützenden, im wesentlichen quaderförmigen Gehäuses **12** mittels eines Mouldverfahrens mit einem thermoplastischen und für einen bestimmten Wellenlängenbereich transparenten Kunststoff, beispielsweise mit einem Kunstharz, umhüllt.

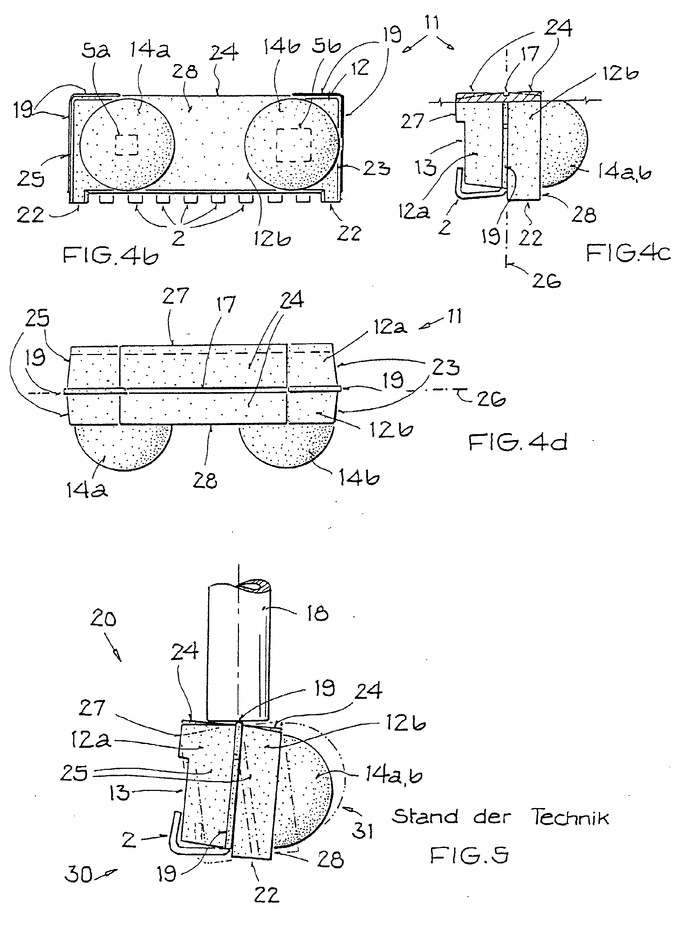

Dabei besteht das Gehäuse **12** aus zwei Teilen: einem ersten Gehäuseteil **12a** mit einer Ausnehmung **13** (in die später die Anschlussbeinchen **2** hineinragen, Fig. 4c) und einem zweiten Gehäuseteil **12b.** Aus einer Ebene **26** zwischen den beiden Gehäuseteilen **12a** und **12b,** in der die Anschlussbeinchen **2** liegen, ragen die noch nicht entfernten Teile des Leiterstreifens **1**. Der erste Gehäuseteil **12a** enthält die einer Leiterplatte zugewandte Unterseite **27** (Bestückungsseite) des Bauelements **11;** der zweite Gehäuseteil **12b** enthält die Oberseite **28** und zwei Auswölbungen **14a** bzw. **14b,** die als Linsen vor dem Transmitter **5a** (Fig. 1) bzw. dem Receiver **5b** (Fig. 1) angeordnet sind.

Die Anschlussbeinchen **2** ragen aus der Seitenfläche **22** des Gehäuses **12** heraus; ihr gegenüber ist die Seitenfläche **24** angeordnet. Aus der Zeichenebene heraus ragt die weitere sichtbare Seitenfläche **25;** ihr gegenüber liegt die (in dieser Ansicht nicht sichtbare) Seitenfläche **23.**

**Fig. 3** zeigt eine Seitenansicht (schnittbildliche Darstellung) des elektronischen Bauelements **11** nach Fig. 2a und 2b bei einem nachfolgenden Fertigungsschritt. Nicht mehr benötigte Teile des Leiterstreifens **1** werden durch Stanzen oder Schneiden entfernt und somit beispielsweise die Anschlussbeinchen **2** auf ihre endgültige Länge gekürzt.

Bei Bauelementen nach dem Stand der Technik hat der Rahmen **8** des Leiterstreifens **1** einen Abstand zum Gehäuse **12,** weshalb sich beim Moulden an allen vier Seitenflächen **22, 23, 24** und **25** ein Grat **19** (Fig. 5) aus dem Mouldwerkstoff (Kunstharz) bildet, der später nur mit großem Aufwand verkleinert, nicht jedoch restlos entfernt werden kann und somit beim Aufnehmen durch eine Bestückungsmaschine große Schwierigkeiten bereitet.

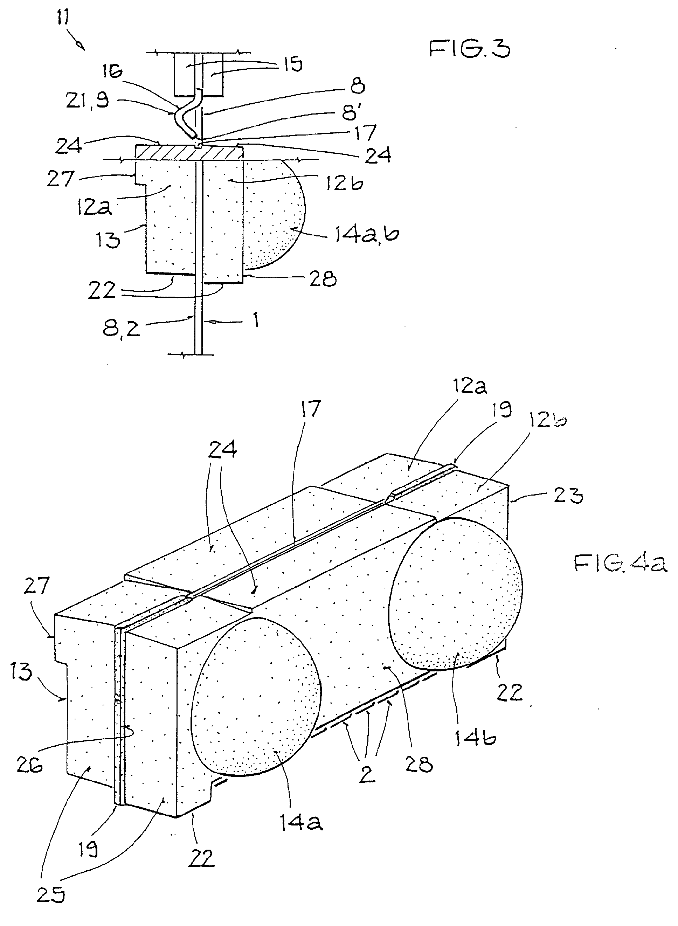

Die Erfindung hingegen sieht vor, dass der Rahmen **8** mit seiner inneren Begrenzung **8'** an den Bereich des späteren Gehäuses **12** direkt angrenzt oder etwas in den Bereich des späteren Gehäuses **12** hineinragt, so dass an der den Anschlussbeinchen **2** gegenüberliegenden Seitenfläche **24** der Grat **19** in einem zusammen hängenden Teil der Seitenfläche **24** in eine Nut **17** übergeht (wie dies auch deutlich aus den Fig. 4a ― d und zugehörender Beschreibung hervor geht). Die Verbreiterung **10** des Rahmenteils **8.1** dient dazu, die Bildung des Grats **19** an der Seitenfläche **24** zu verhindern.

Um das Bauelement **11** aus den noch nicht entfernten Teilen des Leiterstreifens **1** herausnehmen zu können, beispielsweise durch Ausdrücken mit einer kleinen Hebelpresse, ohne dass dies durch die möglicherweise in das Gehäuse **12** hinein ragende Verbreiterung **10** des Leiterstreifens **1** verhindert oder das Gehäuse **12** dadurch beschädigt wird, wird der Leiterstreifen **1** wird im Bereich des Rahmenteils **8.1** von einer Haltevorrichtung **15** festgehalten und der Rahmenteil **8.1** mechanisch, beispielsweise durch Prägen, derart umgeformt, so dass eine Verformung **16,** beispielsweise wie dargestellt in Form einer V-förmigen Sicke, entsteht.

Es ist von Vorteil, wenn in den Rahmenteil **8.1** Öffnungen **9** in Form beispielsweise von Langlöchern eingebracht werden. Diese Langlöcher **9** schwächen das Material des Rahmenteils **8.1,** so dass die Verformung **16** mit verringertem Kraftaufwand und exakt entlang der Stege **21** zwischen diesen Langlöchern **9** hergestellt werden kann.

Durch das Herstellen der Verformung **16** wird der Rahmenteil **8.1** im Idealfall vom Gehäuse **12** weg bzw. im nicht idealen Fall aus dem Gehäuse **12** heraus gezogen, wodurch an dieser Stelle eine schmale und flache Nut **17** entsteht. Dem einschlägig vorgebildeten Fachmann ist es geläufig, statt der hier gezeigten V-förmigen Sicke beispielsweise eine U-förmige Sicke oder eine sonstige mechanische Verformung **16** in beliebiger Art und Weise derart herzustellen, dass sich der Rahmenteil **8.1** verformt und dadurch zwischen Rahmenteil **8.1** und Gehäuse **12** ein Zwischenraum entsteht.

Der Idealfall tritt ein, wenn sich die Verbreiterung **10** des Rahmenteils **8.1** und das Gehäuse **12** gerade noch berühren. Ist die Verbreiterung des Rahmenteils **8.1** im nicht idealen Fall etwas breiter bzw. wird das Gehäuse **12** beim Moulden etwas versetzt oder etwas größer hergestellt, so ragt der Rahmenteil **8.1** mit der Verbreiterung **10** in geringem Maße in das Gehäuse **12** hinein. Bei der Herstellung der Verformung **16** entsteht dann durch das Herausziehen des Rahmenteils **8.1** aus dem Gehäuse **12** die genannte Nut **17** im Gehäuse **12.**

Eine solche Nut **17** stellt jedoch nur einen kleinen "Schönheitsfehler" dar und hat keine weiteren negativen Auswirkungen, da auch trotz einer Nut **17** eine Saugnadel **18** bündig mit dem Gehäuse **12** abschließt und durch die Nut **17,** die sich als dünner, flacher und über die betreffende Fläche des Gehäuses **12** verlaufender Graben auswirkt, nur eine sehr geringe Menge Fremdluft gezogen wird. Das führt lediglich zu einer fast unmerklichen Verminderung der Kraft, mit der ein solches Bauelement **11** von der Saugnadel **18** angezogen wird. Eine Verkantung des Bauelements **11** unterbleibt jedoch.

In den **Fig. 4a-d** ist das fertig gemouldete elektronische Bauelement **11** in vier verschiedenen Ansichten dargestellt. Die aus der Seitenfläche **22** heraus ragenden Anschlussbeinchen **2** sind zweifach abgewinkelt und ragen in die Ausnehmung **13** hinein. Die restlichen, außerhalb des Gehäuses **12** angeordneten Teile des Leiterstreifens **1,** insbesondere der Rahmen **8,** sind entfernt.

Durch die zweifache Abwinkelung der Anschlussbeinchen **2** gibt es zwei Möglichkeiten, das Bauelement **11** auf einer Leiterplatte zu montieren. Die erste Möglichkeit besteht darin, das Bauelement **11** in "Side-View-Position" zu montieren, so dass das Bauelement **11** mit der Seitenfläche **22,** aus der die Anschlussbeinchen **2** heraus ragen, wie dargestellt, auf einer Leiterplatte montiert wird. Die zweite Möglichkeit besteht darin, das Bauelement **11** in "Top-View-Position" zu montieren, so dass das Bauelement **11** mit der Unterseite **28** auf einer Leiterplatte montiert wird.

Der Grat **19** umläuft in der Ebene **26,** in der auch die Anschlussbeinchen **2** liegen, die Seitenflächen **22, 23** und **25.** Die Dicke des Grats **19** entspricht dabei im wesentlichen der Dicke der Anschlussbeinchen **2.** Der Grat **19** bildet sich deshalb, weil die innere Begrenzung **8'** des Rahmens **8** einen Abstand zum Bereich des späteren Gehäuses **12** aufweist (Fig. 2a). Im Gegensatz dazu reicht nun die Verbreiterung **10** des Rahmenteils **8.1** bis dicht an das spätere Gehäuse **12** heran oder ragt sogar etwas in das spätere Gehäuse **12** hinein. Diese Maßnahme führt dazu, dass der Grat **19** in einem zusammen hängenden Teil der Seitenfläche **24** in die Nut **17** übergeht.

Die Saugnadel **18** eines (nicht dargestellten) Bestückungsautomaten kann jetzt ohne Schwierigkeiten das Bauelement **11** an der Seitenfläche **24** des Gehäuses **12** durch Ansaugen aufnehmen, sicher festhalten und präzise beispielsweise auf einer Leiterplatte plazieren, ohne dass sich die Nut **17** störend auswirkt.

Schließlich zeigt **Fig. 5** ein elektronisches Bauelement **20** nach dem Stand der Technik. Ein Grat **19** an der den Anschlussbeinchen **2** gegenüberliegenden Seitenfläche **24,** der in der Trennfläche des Mouldwerkzeugs beim Moulden zwischen den Gehäuseteilen **12a** und **12b** in der Ebene **26** der Anschlussbeinchen **2** entsteht, verursacht einen Abstand zwischen der Saugnadel **18** und dem Gehäuse **12,** so dass das Bauelement **20** überhaupt nicht oder nur mit geringer Kraft und verkantet gehalten wird. Dies hat in unannehmbar vielen Fällen zur Folge, dass das Bauelement **20** eine gekippte Stellung an der Saugnadel **18** einnimmt, beispielsweise eine der dargestellten Miss-Stellungen **30** oder **31** und dadurch auf der Leiterplatte ungenau positioniert wird, was manuelle und somit teure Nacharbeit notwendig macht. Weiterhin ist oft die Folge, dass das Bauelement **20** nicht aufgenommen wird oder auf dem Transportweg verloren geht.

Das erfindungsgemäße gemouldete elektronische Bauelement ist ohne Schwierigkeiten maschinell mit einem Werkzeug (Saugnadel) aufzunehmen und beispielsweise auf einer Leiterplatte richtig zu plazieren. ohne dass das Bauelement verkantet aufgenommen und demzufolge auf der Leiterplatte falsch positioniert wird oder beim Transport verloren geht.

## Patentansprüche

1. Gemouldetes elektronisches Bauelement (11) mit einer Vielzahl in einer Ebene (26) aus einer Seitenfläche (22) eines im wesentlichen quaderförmigen Gehäuses (12), mit Oberseite (27) und Unterseite (28), austretenden Anschlussbeinchen (2) und einem die anderen Seitenflächen (23, 24, 25) in der Ebene (26) der Anschlussbeinchen (2) umlaufenden Grats (19), dessen Dicke im wesentlichen der Dicke der Anschlussbeinchen (2) entspricht, **dadurch gekennzeichnet, dass** an derjenigen Seitenfläche (24), die der Seitenfläche (22) der Anschlussbeinchen (2) gegenüber liegt, in der Ebene (26) der Anschlussbeinchen (2) der Grat (19) in einem zusammen hängenden Teil der Seitenfläche (24) in eine Nut (17) übergeht und so das Bauelement (11) besser von einem Werkzeug auf einer Leiterplatte plaziert werden kann.

2. Gemouldetes elektronisches Bauelement (11) nach Anspruch 1, **dadurch gekennzeichnet, dass** es sich um ein oberflächenmontierbares Bauelement (11) handelt.

3. Gemouldetes elektronisches Bauelement (11) nach Anspruch 2, **dadurch gekennzeichnet, dass** zur Oberflächenmontierbarkeit die Anschlussbeinchen (2) abgewinkelt sind.

4. Gemouldetes elektronisches Bauelement (11) nach Anspruch 2, **dadurch gekennzeichnet, dass** die Anschlussbeinchen (2) zweifach abgewinkelt sind.

5. Gemouldetes elektronisches Bauelement (11) nach Anspruch 4, **dadurch gekennzeichnet, dass** durch die doppelte Abwinkelung das Bauelement (11) mit derjenigen Seitenfläche (22), aus der die Anschlussbeinchen (2) heraus ragen, auf einer Leiterplatte montiert werden kann.

6. Gemouldetes elektronisches Bauelement (11) nach Anspruch 4, **dadurch gekennzeichnet, dass** das Bauelement (11) mit seiner Unterseite (28) montiert wird.

7. Gemouldetes elektronisches Bauelement (11) nach Anspruch 4, **dadurch gekennzeichnet, dass** seine Unterseite (27) eine Ausnehmung (13) für die abgewinkelten Anschlussbeinchen (2) aufweist.

8. Gemouldetes elektronisches Bauelement (11) nach einem der Ansprüche 1 bis 7, **dadurch gekennzeichnet, dass** das Bauelement (11) auf seiner Oberseite (28) zwei Linsen (14a, b) aufweist.
